# EUROPEAN PATENT APPLICATION

(11) **EP 4 459 669 A1**
(43) Date of publication of application: **06.11.2024**
(21) Application number: 22915742.5
(22) Date of filing: 15.12.2022
(51) Int. Cl.: H01L 21/683, B65H 41/00

(54) **SHEET FIXING DEVICE, SHEET PEELING DEVICE, AND SHEET PEELING METHOD**

(30) Priority: 27.12.2021 JP 2021213106
(71) Applicant: MITSUI MINING & SMELTING CO., LTD., Tokyo 141-8584 (JP)
(72) Inventor: YANAI, Takenori, Ageo-shi, Saitama 362-0021 (JP); NAKAMURA, Toshimi, Ageo-shi, Saitama 362-0021 (JP); KOMIYA, Mikiko, Ageo-shi, Saitama 362-0021 (JP); KITABATAKE, Yukiko, Ageo-shi, Saitama 362-0021 (JP); MATSUURA, Yoshinori, Ageo-shi, Saitama 362-0021 (JP)
(74) Representative: Potter Clarkson
(86) International application number: PCT/JP2022/046167
(87) International publication number: WO 2023/127518

(57) **Abstract**

There is provided a sheet fixing apparatus capable of suppressing occurrence of leak between a multilayer sheet and a support stage to secure adhesive force when fixing one surface of the multilayer sheet and releasing a layer on an opposite side thereto. The sheet fixing apparatus includes a support stage for supporting the multilayer sheet, and suction means capable of sucking the multilayer sheet toward the support stage via a suction hole. The support stage has a plate-shaped member having a flat surface on which the multilayer sheet can be placed, a suction hole provided at a position corresponding to an outer peripheral portion of the multilayer sheet in the plate-shaped member, and a step portion provided along an outside of the suction hole in the plate-shaped member. The flat surface of the plate-shaped member has a flatness of 0.30 mm or less as defined by JIS B0621-1984.

## Description

### TECHNICAL FIELD

The present invention relates to a sheet fixing apparatus, a sheet releasing apparatus, and a method for releasing a sheet.

### BACKGROUND ART

In recent years, in order to increase mounting density of a printed wiring board to reduce the size of the printed wiring board, multilayering of printed wiring boards has been widely performed. Such multilayer printed wiring boards are used in many kinds of portable electronic equipment for the purpose of reducing weight and size. This multilayer printed wiring board is required to further reduce the thickness of the interlayer insulation layer, and further reduce the weight as a wiring board.

As a technology that satisfies such demands, a multilayer printed wiring board using a coreless buildup method is employed. A coreless buildup method is a method in which insulation layers and wiring layers are alternately stacked (built up) to form a multilayer structure without using a so-called core substrate. In the coreless buildup method, it is proposed to use a carrier-attached metal foil including a carrier, a release layer, and a metal layer so as to facilitate separation between a support and a multilayer printed wiring board. For example, Patent Literature 1 (JP2005-101137A) discloses the method for producing a package substrate for mounting a semiconductor element, which includes bonding an insulating resin layer onto a carrier surface of a carrier-attached copper foil to form a support, and forming a first wiring conductor on a superthin copper layer side of the carrier-attached copper foil by steps such as photoresist processing, pattern electrolytic copper plating, and resist removal, thereafter, forming a buildup wiring layer, releasing a carrier-attached support substrate, and removing a superthin copper layer.

Incidentally, there is known a technique that uses a suction chuck (also referred to as a suction stage, and a vacuum chuck) that sucks and fixes one surface of a sheet when releasing one layer or a plurality of layers from a stacked sheet having such a release layer, and thereby makes it easy to release a layer on an opposite side thereof. For example, Patent Literature 2 (JP6468682B) discloses a method that bonds a second substrate to a first substrate on which an object to be released is formed, divides the first substrate into a required size and shape, further sucks and fixes the first substrate with a suction chuck having a partial difference in suction ability, and releases the second substrate from the first substrate.

Further, Patent Literature 3 (JP2006-68592A) discloses a substrate mounting stage characterized in that many suction holes leading to a vacuum source and ejection holes leading to a pressure source are formed in a top surface of the substrate mounting stage, and the substrate mounting stage is divided into a plurality of concentrical regions in plan view, and suction and ejection are independently performed for each of the regions. According to the substrate mounting stage, it is possible to horizontally fix a substrate such as a glass substrate without interposing air between the substrate and the stage.

### CITATION LIST

### PATENT LITERATURE

Patent Literature 1: JP2005-101137A
Patent Literature 2: JP6468682B
Patent Literature 3: JP2006-68592A

### SUMMARY OF INVENTION

However, in the releasing method described in Patent Literature 2 or the substrate mounting stage described in Patent Literature 3, the suction force in the sheet end portion is insufficient, and in particular, when the sheet is made of a material having a predetermined rigidity such as a resin, a metal foil, a device, or a composite layer thereof, a fault such as leak might occur between the sheet and the stage.

The inventors have recently found that by providing a suction hole in a position corresponding to an outer peripheral portion of a multilayer sheet, and providing a step portion along an outside of the suction hole, with respect to a support stage having a predetermined flat surface, it is possible to provide a sheet fixing apparatus that can suppress occurrence of leak between the multilayer layer sheet and the support stage and secure an adhesion force when fixing one surface of the multilayer sheet and releasing a layer on an opposite side thereof.

Accordingly, an object of the present invention is to provide a sheet fixing apparatus that can suppress occurrence of leak between a multilayer sheet and a support stage and secure an adhesion force when one surface of the multilayer sheet is fixed and a layer on an opposite side thereof is released.

The present invention provides the following aspects:

### [Aspect 1]

A sheet fixing apparatus for fixing a multilayer sheet, comprising:
a support stage for supporting the multilayer sheet, the support stage having a plate-shaped member having a flat surface on which the multilayer sheet is placeable, a suction hole provided at a position corresponding to an outer peripheral portion of the multilayer sheet in the plate-shaped member, and a step portion provided along an outside of the suction hole in the plate-shaped member; and
suction means capable of sucking the multilayer sheet toward the support stage via the suction hole,
wherein the flat surface has a flatness of 0.30 mm or less as defined by JIS B0621-1984.

### [Aspect 2]

The sheet fixing apparatus according to aspect 1, wherein a distance between the suction hole and the step portion is 30 mm or less.

### [Aspect 3]

The sheet fixing apparatus according to aspect 1 or 2, wherein the suction hole has a recessed portion, and the recessed portion is provided with at least one through-hole penetrating through the plate-shaped member.

### [Aspect 4]

The sheet fixing apparatus according to any one of aspects 1 to 3, wherein when the support stage is seen in plan view, the suction hole has a shape along a contour of the multilayer sheet, and in the suction hole, a partition wall provided parallel to the contour of the multilayer sheet is present to divide the suction hole into a plurality of suction regions.

### [Aspect 5]

The sheet fixing apparatus according to any one of aspects 1 to 4, wherein when the support stage is seen in plan view, a shape of the suction hole is at least one selected from a group consisting of a circular shape, an arc shape, a straight-line shape, and a polygonal shape.

### [Aspect 6]

The sheet fixing apparatus according to any one of aspects 1 to 5, wherein the support stage has a plurality of the suction holes, and the plurality of suction holes are configured as an aggregate that brings about a circle, an arc, a straight line or a polygon as a whole.

### [Aspect 7]

The sheet fixing apparatus according to any one of aspects 1 to 6, wherein the support stage has a positioning pin for positioning the outer peripheral portion of the multilayer sheet onto the suction hole, on a top surface side of the flat surface.

### [Aspect 8]

The sheet fixing apparatus according to any one of aspects 1 to 7, wherein the flat surface has an arithmetic average roughness Ra of 0.01 µm or more and 0.50 µm or less.

### [Aspect 9]

The sheet fixing apparatus according to any one of aspects 1 to 8, wherein the plate-shaped member has a Vickers hardness of 10 HV or more and 3000 HV or less.

### [Aspect 10]

The sheet fixing apparatus according to any one of aspects 1 to 9, wherein the plate-shaped member is composed of at least one selected from a group consisting of stainless steel, Al alloy, carbon tool steel, alloy tool steel, high-speed tool steel, and Ti alloy.

### [Aspect 11]

The sheet fixing apparatus according to any one of aspects 1 to 10, wherein at least an end portion on the suction hole side of the step portion is rounded.

### [Aspect 12]

The sheet fixing apparatus according to any one of aspects 1 to 11, wherein the support stage further comprises a plurality of auxiliary suction holes, separately from the suction hole.

### [Aspect 13]

The sheet fixing apparatus according to any one of aspects 1 to 12, wherein the suction means comprises a lower stage disposed on a side opposite to the flat surface of the plate-shaped member, and the lower stage comprises a gas flow path communicating with the suction hole.

### [Aspect 14]

The sheet fixing apparatus according to aspect 12 or 13, wherein the suction means comprises a lower stage disposed on a side opposite to the flat surface of the plate-shaped member, and the lower stage comprises a gas flow path communicating with the suction hole and the auxiliary suction holes, or comprises a gas flow path communicating with the suction hole and a gas flow path communicating with the auxiliary suction holes separately.

### [Aspect 15]

The sheet fixing apparatus according to aspect 13 or 14, wherein the suction means further comprises a suction pump connected to the gas flow path.

### [Aspect 16]

A sheet releasing apparatus for releasing a multilayer sheet, comprising:
the sheet fixing apparatus according to any one of aspects 1 to 15; and
stress load means for applying stress in contact with the multilayer sheet, the stress load means being provided adjacently to the support stage or provided in the step portion of the support stage, and having a movable contact portion movable to above the flat surface while being in contact with the multilayer sheet.

### [Aspect 17]

The sheet releasing apparatus according to aspect 16, wherein the movable contact portion has a pin shape or a hook shape.

### [Aspect 18]

A method for releasing a sheet, using the sheet releasing apparatus according to aspect 16 or 17, comprising the steps of:
placing a multilayer sheet comprising at least a first layer and a second layer so that a surface of the first layer is in contact with a flat surface of the support stage;
sucking the multilayer sheet toward the support stage via the suction hole by the suction means, thereby fixing the multilayer sheet to the support stage; and
by the stress load means, bringing the movable contact portion into contact with the second layer of the multilayer sheet from the step portion, applying stress in a direction in which the first layer and the second layer are separated from each other, thereby releasing the second layer from the first layer,
wherein a contact region of the movable contact portion and the multilayer sheet has a maximum length of 2 mm or more and 500 mm or less.

### [Aspect 19]

The method for releasing a sheet according to aspect 18, wherein the contact region of the movable contact portion and the multilayer sheet has an area of 5 mm² or more and 120 mm² or less.

### [Aspect 20]

The method for releasing a sheet according to aspect 18 or 19, further comprising a step of applying grease to the surface of the first layer of the multilayer sheet and/or the flat surface of the support stage, before placing the multilayer sheet on the support stage.

### [Aspect 21]

The method for releasing a sheet, comprising a step of fixing one surface of a multilayer sheet by using the sheet fixing apparatus according to any one of aspects 1 to 15, and releasing a layer on an opposite side to the one surface.

### BRIEF DESCRIPTION OF DRAWINGS

Figure 1 is a perspective view showing one example of a sheet fixing apparatus of the present invention.
Figure 2A is a top view showing a plate-shaped member of a support stage of the sheet fixing apparatus shown in Figure 1.
Figure 2B is an enlarged view of a part surrounded by a broken line in the plate-shaped member shown in Figure 2A.
Figure 3A is a perspective view showing a lower stage included by suction means of the sheet fixing apparatus shown in Figure 1.
Figure 3B is a top view of the lower stage shown in Figure 3A.
Figure 4 is a schematic view showing steps of fixing and releasing a multilayer sheet by using a sheet fixing apparatus in which a suction hole and a step portion are provided at positions separated from each other.
Figure 5 is a schematic view showing steps of fixing and releasing the multilayer sheet by using a sheet fixing apparatus in which the suction hole and the step portion are provided at positions close to each other.
Figure 6 is a schematic view showing steps of fixing and releasing the multilayer sheet by using the sheet fixing apparatus in which the suction hole is divided into a plurality of suction regions by partition walls.
Figure 7 is a process flow diagram showing a method for releasing a sheet of the present invention.

### DESCRIPTION OF EMBODIMENTS

### SHEET FIXING APPARATUS

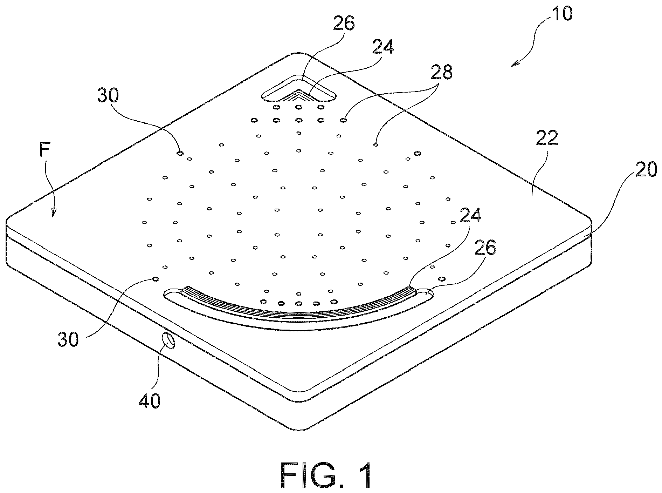

Figure 1 shows an example of a sheet fixing apparatus of the present invention. A sheet fixing apparatus 10 shown in Figure 1 includes a support stage 20, and suction means 40.

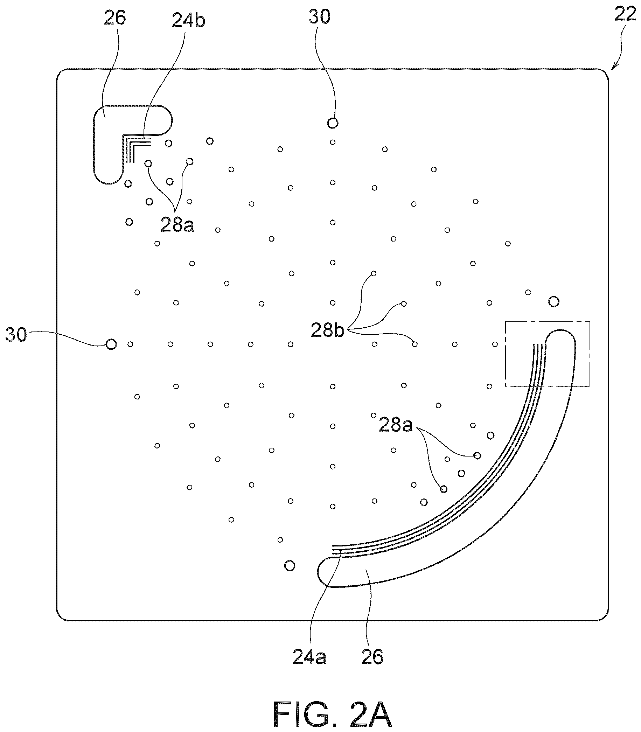

As shown in Figure 1 and Figure 2A, the support stage 20 has a plate-shaped member 22, and a suction hole 24 and a step portion 26 that are provided in the plate-shaped member 22. The plate-shaped member 22 has a flat surface F on which a multilayer sheet can be placed. This flat surface F has a flatness of 0.30 mm or less as defined by JIS B0621-1984. The suction hole 24 is provided at a position corresponding to an outer peripheral portion of the multilayer sheet in the plate-shaped member 22. The step portion 26 is a portion provided along an outside of the suction hole 24 in the plate-shaped member 22, and recessed from the flat surface F. The suction means 40 can suck the multilayer sheet toward the support stage 20 via the suction hole 24. In the sheet fixing apparatus 10 shown in Figure 1, an arc-shaped suction hole 24 that is used when the multilayer sheet is a circular wafer, and an L-shaped suction hole 24 that is used when the multilayer sheet is a rectangular panel are respectively provided in the plate-shaped member 22. Further, an arc-shaped or L-shaped step portions 26 are provided in the plate-shaped member 22 along the outsides of the respective suction holes 24. In other words, the sheet fixing apparatus 10 fixes a multilayer sheet by the support stage 20 supporting the multilayer sheet, and the suction means 40 sucking the multilayer sheet toward the support stage 20. In this manner, by providing the suction hole 24 at the position corresponding to the outer peripheral portion of the multilayer sheet, and providing the step portion 26 along the outside of the suction hole 24, it is possible to provide the sheet fixing apparatus that can suppress occurrence of leak between the multilayer sheet and the support stage 20 and secure an adhesion force, when one surface of the multilayer sheet is fixed and a layer on an opposite side thereof is released.

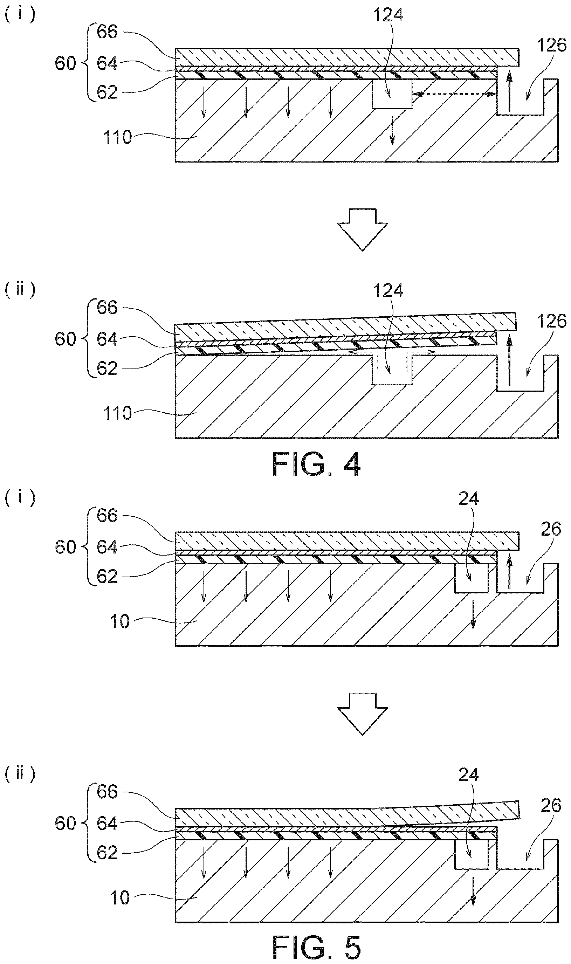

Figures 4 and 5 show schematic views showing steps of placing and fixing a surface on a first layer 62 side of a multilayer sheet 60 including a first layer 62, a release layer 64, and a second layer 66 onto sheet fixing apparatuses 10, 110, and thereafter, releasing the second layer 66. As shown in Figure 4 (i), in the sheet fixing apparatus 110 in which a suction hole 124 is provided at a position separate from an end portion of the multilayer sheet 60, a distance between a spot (that is, a point of application where releasing starts) where a suction force applied to the first layer 62 via the suction hole 124 is large, and a point of power applied to an end portion of the second layer 66 when the second layer 66 is released from the step portion 126 becomes long. Therefore, the force applied to the multilayer sheet 60 is dispersed, and as shown in Figure 4 (ii), the multilayer sheet 60 does not closely contact the support stage 20, which leads to occurrence of leak. As a result, the multilayer sheet 60 is in a state in which it is insufficiently fixed or not fixed at all.

In contrast to this, the sheet fixing apparatus 10 of the present invention is provided with the suction hole 24 at the position corresponding to the outer peripheral portion of the multilayer sheet 60, and therefore, as shown in Figure 5 (i), can locally strongly suck a vicinity of the end portion of the first layer 62. Therefore, when the second layer 66 is released from the step portion 26 provided along the outside of the suction hole 24, the distance between the application point at which the first layer 62 is strongly sucked, and the point of the power applied to the end portion of the second layer 66 becomes short. As a result, it is possible to locally apply force to the end portion of the multilayer sheet 60, and as shown in Figure 5(ii), it is possible to smoothly release the second layer 66. Thus, according to the present invention, it is possible to suppress leak between the multilayer sheet 60 and the support stage 20 and secure an adhesion force when fixing one surface of the multilayer sheet 60 and releasing the layer on an opposite side thereto. As a result, it becomes possible to easily release the layer on the opposite side to the fixed surface of the multilayer sheet 60 without causing a damage or the like. Consequently, according to a preferred aspect of the present invention, there is provided a method of releasing a sheet, which includes steps of fixing one surface of the multilayer sheet 60 by using the sheet fixing apparatus 10, and releasing the layer on the opposite side thereto.

Further, when the first layer 62 of the multilayer sheet 60 is thin, or when the second layer 66 has high rigidity, it may be difficult to release the second layer 66 from the multilayer sheet 60. In this regard, since the force can be locally applied to the end portion of the multilayer sheet 60 by fixing the multilayer sheet 60 by using the sheet fixing apparatus 10 of the present invention as mentioned above, it becomes possible to easily release even the multilayer sheet 60 like this. Accordingly, the sheet fixing apparatus 10 is particularly suitable for use in fixing a wiring board-attached carrier in which a wiring board having a wiring layer, a semiconductor element and/or a resin layer on a rigid carrier formed of glass, ceramics, silicon, or the like, that is, a multilayer sheet.

The wiring board-attached carrier (multilayer sheet) preferably includes a carrier-attached metal foil including an intermediate layer (that is, an optional layer) that is provided as desired, a release layer, and a metal layer on a rigid carrier, and is particularly preferably such that a wiring board is formed on the metal layer of the carrier-attached metal foil. In this case, it is typical that the wiring board is the first layer 62, and the rigid carrier is the second layer 66. A preferred aspect of the carrier-attached metal foil will be described later.

The sheet fixing apparatus 10 (and the sheet releasing apparatus 50 described later) is suitable for use in fixing and releasing the multilayer sheet 60 (a wafer having a diameter of 300 mm, for example) that can be released preferably with a force of 0.1 kgf or more and 10 kgf or less, more preferably 0.5 kgf or more and 8 kgf or less, and even more preferably 1 kgf or more and 5 kgf or less.

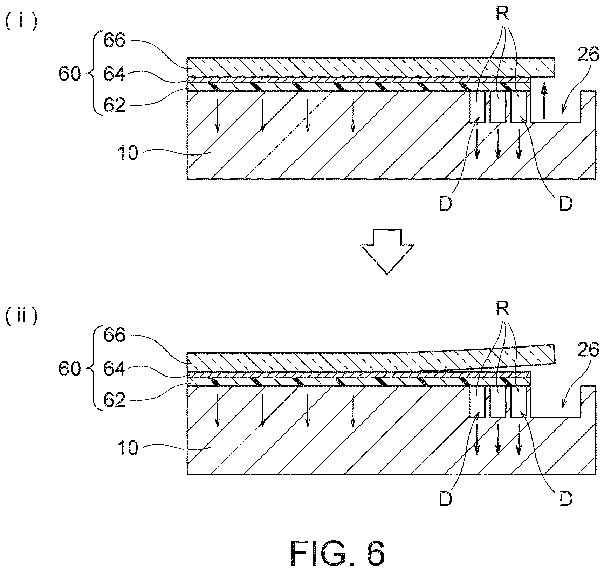

The distance between the suction hole 24 and the step portion 26 in the support stage 20 is preferably 30 mm or less, more preferably 10 mm or less, even more preferably 0.3 mm or more and 5 mm or less, and particularly preferably 0.5 mm or more and 1.5 mm or less. In a range like this, the distance between the spot at which the layer (first layer 62) located on the one surface of the multilayer sheet 60 is strongly sucked, and the point of the power that is applied to the layer (second layer 66) on the opposite side thereto becomes much shorter, and it is possible to suppress occurrence of leak between the multilayer sheet 60 and the support stage 20 more effectively. Here, the distance between the suction hole 24 and the step portion 26 refers to a distance from an inner end surface (side surface closest to the suction hole 24) of the step portion 26 to an outer end surface (side surface closest to the step portion 26) of the suction hole 24 (see Figure 5 (i)). In other words, the above-described distance corresponds to a thickness of the wall that separates the suction hole 24 and the step portion 26. Further, when the suction hole 24 is divided into a plurality of suction regions R by partition walls D as shown in Figure 6 (i), the above-described distance refers to the distance from the inner end surface of the step portion 26 to an outer end surface of the suction region R closest to the step portion 26.

The suction hole 24 is provided at a position corresponding to the outer peripheral portion of the multilayer sheet 60 in the plate-shaped member 22 as mentioned above. The outer peripheral portion of the multilayer sheet 60 herein typically means a region 0 mm or more and 30 mm or less from a peripheral edge of the multilayer sheet 60 toward the center, and more typically means a region 1 mm or more and 20 mm or less, and even more typically means a region 2 mm or more and 10 mm or less.

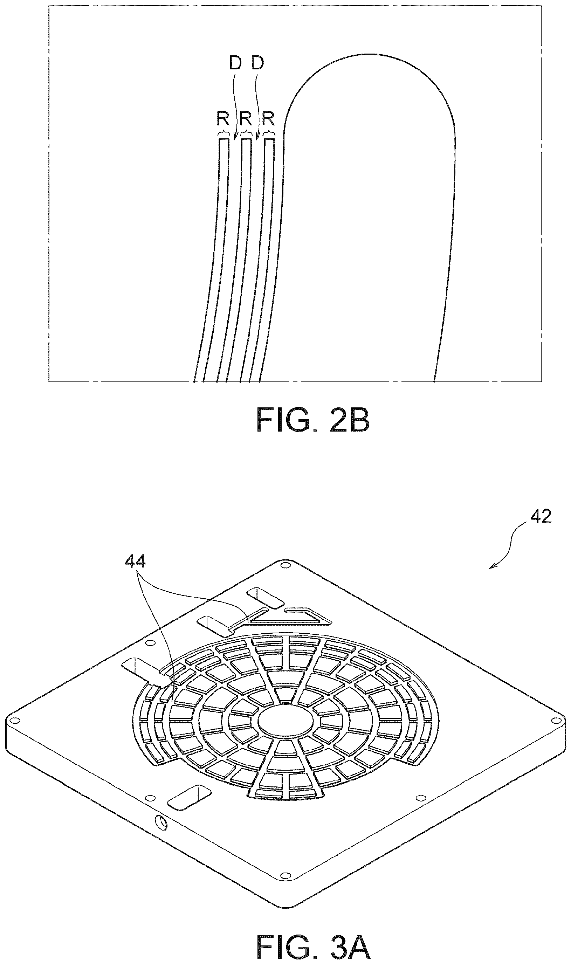

The suction hole 24 preferably has a shape along a contour of the multilayer sheet 60 when the support stage 20 is seen in plan view. Further, as shown in Figure 2B, it is preferable that in the suction hole 24, the partition wall D provided parallel to the contour of the multilayer sheet 60 is present to divide the suction hole 24 into the plurality of suction regions R. Figure 6 schematically shows a step of fixing and releasing the multilayer sheet 60 by using the sheet fixing apparatus 10 in which the suction hole 24 is divided by the partition walls D. In the sheet fixing apparatus 10 shown in Figure 6 (i), the suction hole 24 is divided into the plurality of suction regions R by the partition walls D, and suction of the first layer 62 is performed in the respective suction regions R. In this regard, when the second layer 66 of the multilayer sheet 60 is released, the rigidity of the first layer 62 changes due to separation from the second layer 66, and the first layer 62 may be bent to a suction hole 24 side. Specifically, since the first layer 62 (wiring board, for example) may be a layer including a resin such as mold, a modulus of elasticity of the first layer 62 is typically lower than a modulus of elasticity of the second layer 66 (rigid carrier, for example). For example, the modulus of elasticity of the first layer 62 is less than 1.0 times the modulus of elasticity of the second layer 66, more typically, less than 0.7 times, and even more typically less than 0.5 times. Accordingly, when the second layer 66 is released, bending may occur in such a manner that the first layer 62 is sucked to the suction hole 24 side due to difference in the modulus of elasticity. In this regard, suction of the first layer 62 is dispersed to the respective suction regions R as a result that the suction hole 24 is divided into the plurality of suction regions R, that is, the partition wall D and the suction hole 24 are provided in a slit form, and thereby it is possible to release the second layer 66 while suppressing bending of the first layer 62 as shown in Figure 6 (ii).

When the sheet fixing apparatus 10 is intended to fix a plurality of types of multilayer sheets 60, the plate-shaped member 22 preferably has the suction hole 24 corresponding to the contours of the respective multilayer sheets 60. For example, the plate-shaped member 22 shown in Figure 2A is provided with a first suction hole 24a that is used when the multilayer sheet 60 is a circular wafer, and a second suction hole 24b that is used when the multilayer sheet 60 is a rectangular panel, respectively. Further, when the shape of the multilayer sheet 60 to be fixed is a polygonal shape, it is preferable that the suction hole 24 has a shape along a contour of a corner portion of the multilayer sheet 60 like the second suction hole 24b shown in Figure 2A, from a viewpoint of facilitating fixation and release of the multilayer sheet 60.

The shape of the suction hole 24 is preferably at least one selected from a group consisting of a circular shape, an arc shape, a straight-line shape, and a polygonal shape, more preferably at least one selected from a group consisting of an arc shape, a straight-line shape, and a polygonal shape, and even more preferably an arc shape and/or a straight-line shape, when the support stage 20 is seen in plan view. The suction hole 24 may have a honeycomb shape by partition walls.

A width in a short-side direction (radius direction in the case of a circular shape or an arc shape) of the suction hole 24 is preferably 0.5 mm or more and 30 mm or less, more preferably 1 mm or more and 20 mm or less, even more preferably 1.5 mm or more and 10 mm or less, and particularly preferably 2 mm or more and 5 mm or less. In this manner, it is possible to suppress occurrence of bending more when sucking the multilayer sheet 60. Further, when a length of an entire perimeter (circumference in the case of a circular shape or an arc shape) of the multilayer sheet 60 is 100%, a length in a longitudinal direction (circumferential direction in the case of a circular shape or an arc shape) of the suction hole 24 is preferably 5% or more and 80% or less, more preferably 10% or more and 60% or less, and even more preferably 20% or more and 50% or less. Note that when the suction hole 24 is divided into the plurality of suction regions R, it is preferable to satisfy the above-described width and/or length for each of the suction regions R. Further, when the suction hole 24 has a shape composed of two or more sides like the L-shaped second suction hole 24b shown in Figure 2A, it is preferable that a length obtained by adding up lengths in the longitudinal direction of the respective sides satisfy the above-described length.

The suction hole 24 has a recessed portion, and the recessed portion may be provided with at least one through-hole that penetrates through the plate-shaped member 22. A shape of the through-hole may coincide with or may not coincide with the surface shape of the suction hole 24. In other words, the surface size (hole diameter) of the through-hole provided in the recessed portion may be smaller than the surface size of the suction hole 24.

The support stage 20 may have a plurality of suction holes 24, and the plurality of suction holes 24 may be configured as an aggregate that provides a circle, an arc, a straight line, or a polygon as a whole. In other words, even when the suction hole 24 alone has a shape that is not along the contour of the multilayer sheet 60, if the suction holes 24 have a shape along the contour of the multilayer sheet 60 as a whole, it is possible to suck and fix the multilayer sheet 60 while suppressing bending.

The flat surface F of the plate-shaped member 22 has a flatness of 0.30 mm or less, preferably 0.01 mm or more and 0.10 mm or less, and even more preferably 0.03 mm or more and 0.07 mm or less, as defined by JIS B0621-1984. In this manner, when a multilayer sheet is placed and sucked onto the support stage 20, it is possible to fix the multilayer sheet 60 while suppressing bending. The flatness of the flat surface F can be measured by using a commercially available three-dimensional measuring machine.

The flat surface F preferably has an arithmetic average roughness Ra of 0.01 µm or more and 0.50 µm or less, more preferably 0.02 µm or more and 0.40 µm or less, and even more preferably 0.05 µm or more and 0.30 µm or less, as measured in accordance with JIS B 0601-2001. In such a range, it is possible to suppress bending of the sheet more effectively when fixing a multilayer sheet. The arithmetic average roughness Ra can be calculated by measuring a surface profile of a predetermined measurement length (for example, 130 µm) in the flat surface F by a commercially available laser microscope.

The plate-shaped member 22 preferably has a Vickers hardness of 10 HV or more and 3000 HV or less, more preferably 10 HV or more and 2000 HV or less, even more preferably 20 HV or more and 800 HV or less, and particularly preferably 40 HV or more and 400 HV or less. In this manner, it is possible to effectively prevent wear due to contact and rubbing with a multilayer sheet or the like. Note that the Vickers hardness herein is measured in accordance with "Vickers hardness test" described in JIS Z2244-2009.

The plate-shaped member 22 is preferably composed of at least one selected from a group consisting of stainless steel, Al alloy, carbon tool steel (carbon steel obtained by containing a predetermined amount of carbon, silicon, and manganese in iron, as defined in JIS G4401-2009), alloy tool steel (tool steel obtained by adding a small amount of tungsten, chrome, vanadium, and the like to carbon tool steel, as defined in JIS G4404-2015), high speed tool steel (tool steel obtained by adding a large amount of tungsten, chrome, vanadium, molybdenum, and the like to carbon tool steel, as defined in JIS G4403-2015), and Ti alloy, more preferably composed of at least one selected from a group consisting of stainless steel, Al alloy, carbon tool steel, alloy tool steel, and high speed tool steel, and even more preferably composed of stainless steel and/or Al alloy. Preferred examples of the Al alloy include A1000 series containing 99% or more of Al, A5000 series (for example, A5052) in which Mg is added to Al, and A6000 series, as defined in JIS H4000-2014. From a viewpoint of preventing wear due to contact and rubbing with a multilayer sheet or the like, the Al alloy may have a hard-alumite-treated coating film.

The thickness of the plate-shaped member 22 is preferably 3 mm or more and 1000 mm or less, more preferably 5 mm or more and 500 mm or less, and even more preferably 10 mm or more and 300 mm or less, from a viewpoint of maintaining rigidity, and securing workability and productivity at the time of manufacturing the plate-shaped member 22.

The step portion 26 is a portion recessed from the flat surface F provided on the plate-shaped member 22 as mentioned above, and is a portion that does not contact the multilayer sheet 60 when the multilayer sheet 60 is placed on the support stage 20. Therefore, when releasing the multilayer sheet 60, in a state in which the layer (first layer 62) located on the one surface of the multilayer sheet 60 is fixed to the sheet fixing apparatus 10 when releasing the multilayer sheet 60, it is possible to apply stress to an end portion of the layer (second layer 66) located on the other surface of the multilayer sheet 60 from the step portion 26.

The step portion 26 may have a groove-shaped region as shown in Figure 2A. A depth (height difference from the flat surface F) of the step portion 26 is preferably 1 mm or more and 200 mm or less, and more preferably 3 mm or more and 100 mm or less, from a viewpoint of the plate-shaped member 22 maintaining rigidity as a whole, and securing easiness at the time of releasing the multilayer sheet 60.

An end portion on at least a suction hole 24 side of the step portion 26 is preferably rounded, from a viewpoint of preventing scratches to the multilayer sheet 60, a flaw of the suction hole 24, or the like.

The support stage 20 preferably further includes a plurality of auxiliary suction holes 28 separately from the suction hole 24, as shown in Figure 1. The auxiliary suction holes 28 are preferably provided on a center side from the suction hole 24 in the plate-shaped member 22, and in this manner, it is possible to suck and fix not only the vicinity of the end portion but also the center portion of the multilayer sheet 60. However, since the sheet fixing apparatus 10 suppresses breakage of the multilayer sheet 60, occurrence of leak between the multilayer sheet and the support stage 20, and the like due to release by strongly sucking the vicinity of the end portion of the multilayer sheet 60 as mentioned above, the suction force via the auxiliary suction holes 28 is desirably smaller than the suction force via the suction hole 24. Control of such a suction force can be favorably performed by making a hole diameter of the auxiliary suction hole 28 smaller than that of the suction hole 24, or separately sucking the suction hole 24 and the auxiliary suction hole 28 via respective gas flow paths as described later. A shape of the auxiliary suction hole 28 is not particularly limited, but is preferably a circular shape and/or a polygonal shape (for example, a quadrangular shape).

A diameter of a circumcircle of the auxiliary suction hole 28 is preferably 0.2 mm or more and 50 mm or less, more preferably 0.5 mm or more and 30 mm or less, and even more preferably 1 mm or more and 20 mm or less. Further, the plurality of auxiliary suction holes 28 may have hole areas different from one another. For example, the auxiliary suction holes 28 shown in Figure 2A have first auxiliary suction holes 28a present in a vicinity of the suction hole 24 and each having a large hole diameter, and second auxiliary suction holes 28b present in the other spots and each having a small hole diameter. In this manner, the suction force in the vicinity of the end portion of the multilayer sheet 60 can be controlled so as to be larger as compared with the suction force in the vicinity of the center of the multilayer sheet 60.

In order to position the outer peripheral portion of the multilayer sheet 60 onto the suction hole 24, the support stage 20 preferably has positioning pins 30 on a top surface side of the flat surface F, and more preferably has the positioning pins 30 only in a peripheral edge portion outward of the auxiliary suction holes 28, on the top surface side of the flat surface F, as shown in Figure 1. From a viewpoint of performing reliable positioning, the positioning pin 30 preferably has a circular shape or a quadrangular shape. Further, the positioning pin 30 is preferably made of stainless steel, Al alloy, carbon tool steel, alloy tool steel, high speed tool steel or a combination thereof, and particularly preferably made of stainless steel, or Al alloy. This positioning pin 30 makes it possible to match the multilayer sheet 60 to the suction hole 24 more easily and quickly at the time of releasing. In other words, the process time period is shortened.

The suction means 40 preferably includes a lower stage 42 disposed on an opposite side to the flat surface F of the plate-shaped member 22. It is preferable that the lower stage 42 includes a gas flow path 44 that communicates with the suction hole 24 as shown in Figure 3A, from a viewpoint of stably performing suction.

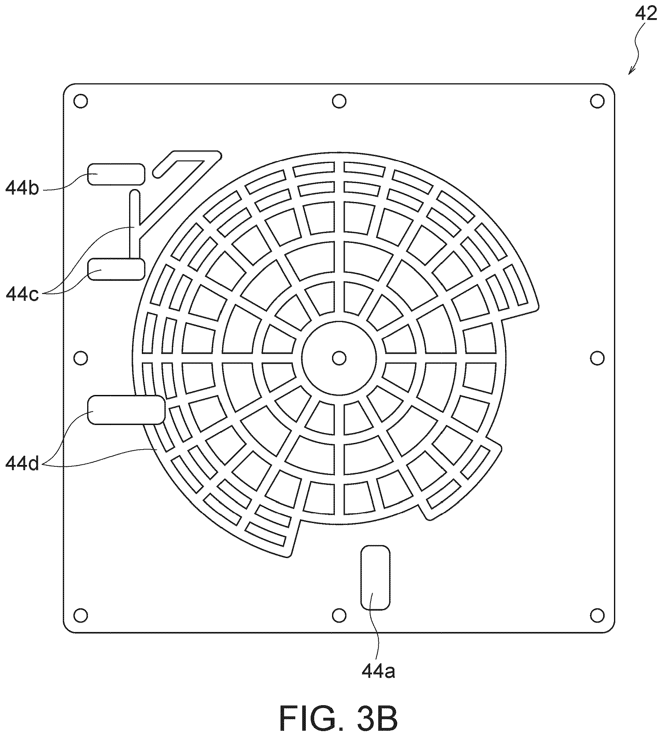

When the support stage 20 further includes the auxiliary suction holes 28, the lower stage 42 may include a gas flow path 44 that communicates with the suction hole 24 and the auxiliary suction holes 28 and may include the gas flow path 44 that communicates with the suction hole 24 and the gas flow path 44 that communicates with the auxiliary suction holes 28 separately. The lower stage 42 shown in Figure 3B includes a first gas flow path 44a and a second gas flow path 44b that communicate with the suction hole 24, and includes a third gas flow path 44c and a fourth gas flow path 44d that communicate with the auxiliary suction holes 28. By including the plurality of gas flow paths 44 in this manner, it becomes possible to adjust the suction force for each of the gas flow paths, and the suction force of the suction hole 24 can be easily controlled to be larger than the suction force of the auxiliary suction holes 28. In addition, even when leak occurs in some of the gas flow paths and suction cannot be performed, it is possible to perform suction normally in the suction hole 24 and/or the auxiliary suction holes 28 that communicate with the other gas flow path, and therefore it is possible to minimize the influence of malfunctioning due to the leak or the like.

When the lower stage 42 has the gas flow path 44, the suction means 40 preferably further includes a suction pump (not illustrated) connected to the gas flow path 44. In particular, when the lower stage includes the gas flow path 44 that communicates with the suction hole 24 and the gas flow path 44 that communicates with the auxiliary suction holes 28 separately, the suction means 40 preferably includes a suction pump connected to the gas flow path 44 communicating with the suction hole 24, and a suction pump connected to the gas flow path 44 communicating with the auxiliary suction hole 28 separately. In this manner, the suction force of the suction hole 24 is easily controlled to be larger than the suction force of the auxiliary suction holes 28. A type of the suction pump is not particularly limited as long as the suction pump can suck and fix the multilayer sheet to the support stage 20, but, for example, a rotary pump can be used. Alternatively, the suction means 40 may perform suction by using a blower or a compressor.

### SHEET RELEASING APPARATUS

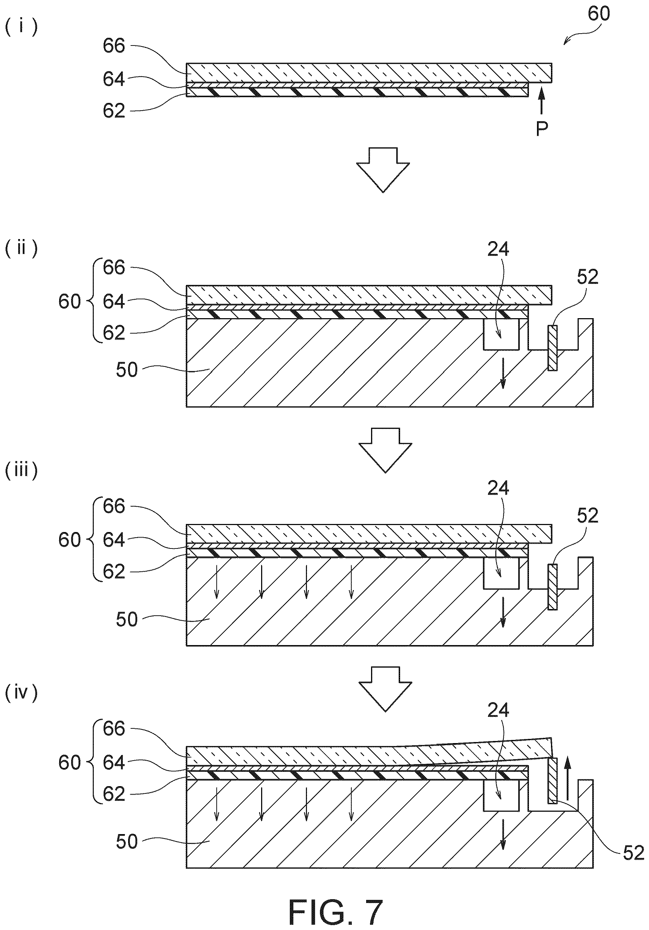

According to a preferred aspect of the present invention, a sheet releasing apparatus for releasing a multilayer sheet is provided. Figure 7 shows a sheet releasing apparatus of the present invention and a sheet releasing step by using it. A sheet releasing apparatus 50 shown in Figure 7 (ii) to (iv) includes the aforementioned sheet fixing apparatus 10 and stress load means for contacting the multilayer sheet 60 to apply stress thereto. The stress load means is provided adjacently to the support stage 20, or provided in the step portion 26 of the support stage 20. The stress load means has a movable contact portion 52 movable to above the flat surface F while contacting the multilayer sheet 60.

In other words, the sheet releasing apparatus 50 can suck and fix the layer (first layer 62) located on the one surface of the multilayer sheet 60 by the sheet fixing apparatus 10 as mentioned above. Then, in the state in which the one surface of the multilayer sheet 60 is fixed, the movable contact portion 52 is moved upward by the stress load means, whereby the layer (second layer 66) located on the other surface of the multilayer sheet 60 contacts the movable contact portion 52, and the layer located on the other surface is pushed upward (in an opposite direction to the suction direction) to be released.

The movable contact portion 52 of the stress load means preferably has a pin shape or a hook shape, and more preferably has a pin shape, and favorably has an arc shape when seen in top view. Further, the movable contact portion 52 has a sufficiently large contact region with the multilayer sheet 60, and thereby can more effectively suppress a damage to the multilayer sheet 60. From this viewpoint, a surface on a side in contact with the multilayer sheet 60 of the movable contact portion 52 preferably has an area of 5 mm² or more and 120 mm² or less, and more preferably 10 mm² or more and 80 mm² or less.

### SHEET RELEASING METHOD

According to a preferred aspect of the present invention, a sheet releasing method using the sheet releasing apparatus is provided. This method includes respective steps of (1) trimming of a multilayer sheet, which is performed as desired, (2) placement of the multilayer sheet, (3) suction and fixation of the multilayer sheet, and (4) release of the multilayer sheet. Hereinafter, each of the steps (1) to (4) will be described with reference to Figure 7.

### (1) Trimming of Multilayer Sheet (Optional Step)

The multilayer sheet 60 including at least the first layer 62 and the second layer 66 is provided. The multilayer sheet 60 may include as desired the release layer 64 that is interposed between the first layer 62 and the second layer 66 to facilitate release of both of them or may have other layers than these layers.

As shown in Figure 7 (i), the second layer 66 of the multilayer sheet 60 preferably has a pressurizable region P protruded sideward as compared with the first layer 62. Therefore, prior to fixation of the multilayer sheet 60, the outer peripheral portion of the first layer 62 is preferably trimmed. A trimming method is not particularly limited, and a known technique can be employed.

The multilayer sheet 60 is preferably a rigid sheet having rigidity. From such a viewpoint, a modulus of elasticity (Young's modulus) of the multilayer sheet 60 is preferably 30 GPa or more and 600 GPa or less, more preferably 40 GPa or more and 400 GPa or less, and even more preferably 50 GPa or more and 250 GPa or less. Vickers hardness of the multilayer sheet is preferably 20 HV or more and 2500 HV or less, more preferably 30 HV or more and 2000 HV or less, and even more preferably 40 HV or more and 800 HV or less. The first layer 62 and the second layer 66 of the multilayer sheet 60 may be made of a same material as each other, or may be made of different materials. When the first layer 62 and the second layer 66 are made of different materials, at least the second layer 66 preferably has the above-described modulus of elasticity and/or Vickers hardness.

As mentioned above, the multilayer sheet 60 is particularly preferably a wiring board-attached carrier in which a wiring board having a wiring layer, a semiconductor element and/or a resin layer are formed on a rigid carrier made of glass, ceramics, silicon, or the like. In this case, it is typical that the wiring board is the first layer 62 and the rigid carrier is the second layer 66.

### (2) Placement of Multilayer Sheet

The multilayer sheet 60 is placed so that the surface of the first layer 62 is in contact with the flat surface F of the support stage 20 (see Figure 7 (ii)). At this time, the multilayer sheet 60 is preferably placed so that a side end of the first layer 62 and the inner end surface of the step portion 26 coincide with each other, that is, the side end of the first layer 62 is located along the side surface closest to the suction hole 24, of the step portion 26, and so that the end portion or the pressurizable region P of the second layer 66 is located above the step portion 26. It is particularly preferable to design the support stage 20 so that the multilayer sheet 60 is placed in this manner, and the distance between the suction hole 24 and the step portion 26 is made short as mentioned above (for example, 1 mm). In this manner, it is possible to release the second layer 66 (for example, the rigid carrier) while extremely effectively suppressing occurrence of leak between the first layer 62 (for example, the wiring board) and the support stage 20.

Before placing the multilayer sheet 60 on the support stage 20, it is preferable to apply grease to the surface of the first layer 62 of the multilayer sheet 60 and/or the flat surface F of the support stage 20. Worked penetration at 25°C measured in accordance with JIS K2220-2013 of this grease is preferably 10 or more and 1000 or less, and more preferably 50 or more and 700 or less. Further, a voltaic content of the grease when heated at 99°C for 22 hours is preferably 10% or more and 70% or less, and more preferably 30% or more and 50% or less. Preferred examples of the grease include silicone-based grease, polyglycol-based grease, synthetic hydrocarbon oil-based grease, and combinations thereof.

### (3) Suction and Fixation of Multilayer Sheet

As shown in Figure 7 (iii), the multilayer sheet 60 is sucked toward the support stage 20 via the suction hole 24 by the suction means 40. In this manner, it is possible to fix the multilayer sheet 60 to the support stage 20.

As for a preferred suction and fixing method of the multilayer sheet 60 using the sheet releasing apparatus 50, the preferred aspect mentioned above concerning the sheet fixing apparatus 10 is applied as it is.

### (4) Release of Multilayer Sheet

As shown in Figure 7 (iv), by the stress load means, the movable contact portion 52 is brought into contact with the second layer 66 of the multilayer sheet 60 from the step portion 26, and stress is applied in a direction (opposite direction to the suction direction) in which the first layer 62 and the second layer 66 are separated from each other. This makes it possible to release the second layer 66 of the multilayer sheet 60 from the first layer 62.

The stress applied to the multilayer sheet 60 can be properly adjusted according to the size or the like of the multilayer sheet 60. For example, when the multilayer sheet 60 is a wafer having a diameter of 300 mm, the stress that is applied to the multilayer sheet 60 is preferably 0.1 kgf or more and 10 kgf or less, more preferably 0.5 kgf or more and 8 kgf or less, and more preferably 1 kgf or more and 5 kgf or less. In this manner, it is possible to smoothly release the second layer 66 of the multilayer sheet 60 from the first layer 62. Note that the above-described stress can be measured by using a commercially available force gauge.

Note that before the releasing, it is preferable to make an incision in the vicinity of the release layer 64 of the multilayer sheet 60, and this reduces the stress applied at the time of start of release, and can allow the release to proceed more smoothly. In other words, a rotary blade (for example, a diameter of 45 mm, a blade thickness of 0.3 mm, a blade angle of 21°, a material: tungsten) is inserted toward a center portion side of the first layer 62, the release layer 64, and the second layer 66 from a corner of the incision. At this time, an insertion angle θ of the rotary blade to the principal surface of the multilayer sheet 60 when the multilayer sheet 60 is seen in sectional view is 15°. Further, an insertion width of the rotary blade into the multilayer sheet 60 is, for example, 2 mm. In this manner, a gap can be favorably formed between the first layer 62 and the second layer 66.

When the movable contact portion 52 is brought into contact with the second layer 66 of the multilayer sheet 60, a maximum length of a contact region of the movable contact portion 52 and the multilayer sheet 60 is 2 mm or more and 500 mm or less, preferably 5 mm or more and 300 mm or less, and even more preferably 10 mm or more and 100 mm or less. In this manner, stress per unit length that is applied to the multilayer sheet 60 can be reduced, and a damage to the multilayer sheet 60 can be more effectively suppressed. Note that the maximum length of the contact region herein means a distance between two points that are the most separated in the contact region, and typically means a length in a longitudinal direction of the contact region. From a similar viewpoint, an area of the contact region of the movable contact portion 52 and the multilayer sheet 60 is preferably 5 mm² or more and 120 mm² or less, more preferably 10 mm² or more and 80 mm² or less, and even more preferably 30 mm² or more and 70 mm² or less.

### Carrier-attached Metal Foil

As mentioned above, the multilayer sheet 60 that is an object to be fixed and/or released in the method of the present invention preferably includes a carrier-attached metal foil including a rigid carrier, an intermediate layer as desired, a release layer, and a metal layer in order.

The rigid carrier is preferably made of glass, polycrystalline silicon, single crystal silicon or ceramics. For example, it is preferable that the rigid carrier may function as a support having rigidity such as a glass plate, a ceramic plate, a silicon wafer, and a metal plate. Preferred examples of ceramics composing the rigid carrier include alumina, zirconia, silicon nitride, aluminum nitride, and other various fine ceramics. More preferably, it is a material with a coefficient of thermal expansion (CTE) of less than 25 ppm/K (typically, 1.0 ppm/K or more and 23 ppm/K or less) from a viewpoint of prevention of warpage of the coreless support with heating at the time of mounting a semiconductor element, and examples of such a material include glass, silicon, ceramics and the like as mentioned above. Further, from a viewpoint of securing handleability and flatness at the time of chip mounting, Vickers hardness of the rigid carrier is preferably 100 HV or more, and more preferably 150 HV or more and 2500 HV or less. As the material that satisfies these properties, the rigid carrier is preferably made of glass, silicon, or ceramics, more preferably made of glass or ceramics, and particularly preferably made of glass. An example of the rigid carrier made of glass includes a glass plate, for example. When glass is used as the rigid carrier, there is an advantage such as being able to extremely smoothen the surface of the metal layer since the glass carrier has a light weight, a low thermal expansion coefficient, a high insulation property, stiffness, and a flat surface. In addition, when the rigid carrier is glass, there are advantages such as having surface flatness (coplanarity) which is advantageous for microcircuit formation and having chemical resistance in desmearing in the wiring producing process and various plating processes. Preferred examples of glass composing the rigid carrier include quartz glass, borosilicate glass, alkali-free glass, soda lime glass, aluminosilicate glass, and combinations thereof, more preferred examples include alkali-free glass, soda lime glass, and combinations thereof, and a particularly preferred example is alkali-free glass. Alkali-free glass is glass containing an alkaline earth metal oxide such as a silicon dioxide, aluminum oxide, boron oxide, calcium oxide, and barium oxide as a main component, and further containing boric acid, but containing substantially no alkali metal. The alkali-free glass has an advantage of being able to minimize warpage of glass in the process involving heating, because a thermal expansion coefficient thereof is low and stable in a range of 3 ppm/K or more and 5 ppm/K or less in a wide temperature range from 0°C to 350°C. A thickness of the rigid carrier is preferably 100 µm or more and 2000 µm or less, more preferably 300 µm or more and 1800 µm or less, and even more preferably 400 µm or more and 1100 µm or less. If the rigid carrier has the thickness in such a range, it is possible to realize reduction in thickness of wiring while securing appropriate strength that does not hinder handling, and reduction in warpage that occurs at the time of mounting electronic components.

The intermediate layer that is provided as desired may have single-layer configuration, or a configuration of two layers or more. When the intermediate layer is made of two or more layers, the intermediate layer includes a first intermediate layer provided directly above the rigid carrier, and a second intermediate layer provided adjacently to the release layer. The first intermediate layer is preferably a layer made of at least one metal selected from a group consisting of Ti, Cr, Al, and Ni, from a viewpoint of securing adhesion with the rigid carrier. The first intermediate layer may be a pure metal or an alloy. A thickness of the first intermediate layer is preferably 5 nm or more and 500 nm or less, more preferably 10 nm or more and 300 nm or less, even more preferably 18 nm or more and 200 nm or less, and particularly preferably 20 nm or more and 100 nm or less. The second intermediate layer is preferably a layer made of Cu from a viewpoint of controlling release strength from the release layer to a desired value. A thickness of the second intermediate layer is preferably 5 nm or more and 500 nm or less, more preferably 10 nm or more and 400 nm or less, even more preferably 15 nm or more and 300 nm or less, and particularly preferably 20 nm or more and 200 nm or less. Another intervening layer may be present between the first intermediate layer and the second intermediate layer, and examples of a composing material of the intervening layer include an alloy of Cu and at least one metal selected from a group consisting of Ti, Cr, Mo, Mn, W, and Ni. On the other hand, when the intermediate layer has a single-layer configuration, the aforementioned first intermediate layer may be adopted as the intermediate layer as it is, or the first intermediate layer and the second intermediate layer may be replaced with one layer of an intermediate alloy layer. The intermediate alloy layer is preferably made of a copper alloy in which a content of at least one metal selected from the group consisting of Ti, Cr, Mo, Mn, W, Al, and Ni is 1.0at% or more, and a Cu content is 30at% or more. A thickness of the intermediate alloy layer is preferably 5 nm or more and 500 nm or less, more preferably 10 nm or more and 400 nm or less, even more preferably 15 nm or more and 300 nm or less, and particularly preferably 20 nm or more and 200 nm or less. Note that the aforementioned thickness of each of the layer is a value measured by analyzing a layer section with an energy dispersive X-ray spectroscopic analyzer of a transmission electron microscope (TEM-EDX). The metal composing the intermediate layer may contain unavoidable impurities derived from a raw material component, a film forming process and the like. Further, when the intermediate layer is exposed to an atmosphere after film formation of the intermediate layer, presence of oxygen mixed due to this is allowed. The intermediate layer may be a layer produced by any method, but is particularly preferably a layer formed by a magnetron sputtering method using a metal target because uniformity of film thickness distribution can be provided.

The release layer is a layer that makes it possible or easy to release the rigid carrier, and an intermediate layer when it is present. The release layer may be either one of an organic release layer and an inorganic release layer. Examples of the organic component used in the organic release layer include a nitrogen-containing organic compound, a sulfur-containing organic compound, carboxylic acid, and the like. Examples of the nitrogen-containing compound include a triazole compound, an imidazole compound, and the like. On the other hand, examples of the inorganic compound used in an inorganic release layer include a metal oxide or metal oxynitride including at least one of Cu, Ti, Al, Nb, Zr, Cr, W, Ta, Co, Ag, Ni, In, Sn, Zn, Ga, and Mo, or carbon or the like. Among them, the release layer is preferably a layer mainly containing carbon from the viewpoint of ease of releasing and layer formation, more preferably a layer mainly made of carbon or hydrocarbon, and even more preferably a layer made of amorphous carbon which is a hard carbon film. In this case, a carbon concentration measured by XPS of the release layer (that is, a carbon-containing layer) is preferably 60at% or more, more preferably 70at% or more, even more preferably 80at% or more, and particularly preferably 85at% or more. An upper limit value of the carbon concentration is not particularly limited and may be 100at%, but is realistically 98at% or less. The release layer may contain unavoidable impurities (for example, oxygen, carbon, hydrogen and the like derived from an ambient environment such as an atmosphere). Further, metal atoms of other types than a type of metal contained as the release layer may be mixed into the release layer due to the film forming method of a metal layer or the like that is stacked later. When the carbon-containing layer is used as the release layer, mutual diffusion and reactivity with the carrier are small, and even when subjected to press working or the like at a temperature exceeding 300°C, it is possible to prevent mutual diffusion of metal elements due to high-temperature heating between the metal layer and the joining interface, and maintain a state in which release and removal of the carrier are easy. The release layer is preferably a layer formed by a vapor phase method such as sputtering in terms of suppressing excessive impurities in the release layer, continuous productivity of other layers, and the like. A thickness in the case of using a carbon-containing layer as the release layer is preferably 1 nm or more and 20 nm or less, and more preferably 1 nm or more and 10 nm or less. The thickness is a value measured by analyzing the layer section by an energy diffusive X-ray spectroscopic analyzer of a transmission electron microscope (TEM-EDX).

The release layer may include respective layers of a metal oxide layer and a carbon-containing layer, or a layer including both a metal oxide and carbon. In particular, when the carrier-attached metal foil includes an intermediate layer, the carbon-containing layer contributes to stable release of the rigid carrier, and the metal oxide layer can more effectively suppress diffusion due to heating of metal elements derived from the intermediate layer and the metal layer, as a result of which, it becomes possible to maintain stable releasability even after being heated at a high temperature of, for example, 350°C or more. The metal oxide layer is preferably a layer containing an oxide of a metal composed of Cu, Ti, Al, Nb, Zr, Cr, W, Ta, Co, Ag, Ni, In, Sn, Zn, Ga, Mo or combinations thereof. The metal oxide layer is particularly preferably a layer formed by a reactive sputtering method in which a metal target is used and sputtering is performed under an oxidizing atmosphere, from a viewpoint of being able to easily control a film thickness by adjustment of a film forming time period. The thickness of the metal oxide layer is preferably 0.1 nm or more and 100 nm or less. An upper limit value of the thickness of the metal oxide layer is more preferably 60 nm or less, even more preferably 30 nm or less, and particularly preferably 10 nm or less. The thickness is a value measured by analyzing the layer section by an energy diffusive X-ray spectroscopic analyzer of a transmission electron microscope (TEM-EDX). At this time, an order in which the metal oxide layer and the carbon layer are stacked as the release layer is not particularly limited. Further, the release layer may be present in a state of a mixed phase (that is, a layer containing both metal oxide and carbon) in which a boundary between the metal oxide layer and the carbon-containing layer is not clearly specified.

Similarly, from the viewpoint of maintaining stable releasability even after heat treatment at a high temperature, the release layer may be a metal-containing layer in which a surface on a side adjacent to the metal layer is a fluoridation treated surface and/or a nitridation treated surface. In the metal-containing layer, a region (hereinafter, referred to as a "(F+N) region") in which a sum of a content of fluorine and a content of nitrogen is 1.0at% or more is preferably present throughout a thickness of 10 nm or more, and the (F+N) region is preferably present on the metal layer side of the metal-containing layer. The thickness of the (F+N) region (SiOz conversion) is a value specified by performing depth-direction element analysis of the carrier-attached metal foil by using XPS. The fluoridation treated surface or the nitridation treated surface can be preferably formed by reactive ion etching (RIE: Reactive ion etching), or a reactive sputtering method. On the other hand, the metal elements contained in the metal-containing layer preferably has a negative standard electrode potential. Preferred examples of the metal elements contained in the metal-containing layer include Cu, Ag, Sn, Zn, Ti, Al, Nb, Zr, W, Ta, Mo, and combinations thereof (for example, alloys and intermetallic compounds). A content rate of the metal elements in the metal-containing layer is preferably 50at% or more and 100at% or less. The metal-containing layer may be a single layer composed of one layer, or a multilayer composed of two layers or more. The thickness of the entire metal-containing layer is preferably 10 nm or more and 1000 nm or less, more preferably 30 nm or more and 500 nm or less, even more preferably 50 nm or more and 400 nm or less, and particularly preferably 100 nm or more and 300 nm or less. The thickness of the metal-containing layer itself is a value measured by analyzing the layer section by an energy diffusive X-ray spectroscopic analyzer of a transmission electron microscope (TEM-EDX).

Alternatively, the release layer may be a metal oxynitride-containing layer instead of a carbon layer or the like. A surface on an opposite side (that is, a metal layer side) to the rigid carrier, of the metal oxynitride-containing layer preferably contains at least one metal oxynitride selected from a group consisting of TaON, NiON, TiON, NiWON, and MoON. Further, the surface on the rigid carrier side of the metal oxynitride-containing layer preferably contains at least one selected from a group consisting of Cu, Ti, Ta, Cr, Ni, Al, Mo, Zn, W, TiN, and TaN, from a viewpoint of securing adhesion between the rigid carrier and the metal layer. In this manner, the number of foreign matter particles on the metal layer surface is suppressed to improve circuit formability, and it is possible to maintain stable release strength even after being heated for a long time period at a high temperature. The thickness of the metal oxynitride-containing layer is preferably 5 nm or more and 500 nm or less, more preferably 10 nm or more and 400 nm or less, even more preferably 20 nm or more and 200 nm or less, and particularly preferably 30 nm or more and 100 nm or less. The thickness is a value measured by analyzing the layer section by an energy diffusive X-ray spectroscopic analyzer of a transmission electron microscope (TEM-EDX).

The metal layer is a layer made of a metal. The metal layer may have a single-layer configuration, or a configuration of two layers or more. When the metal layer is composed of layers of two layers or more, the metal layer can have a configuration in which respective metal layers from a first metal layer to an m^{th} metal layer (m is an integer of 2 or more) are stacked in order on an opposite surface side to the rigid carrier, of the release layer. The thickness of the entire metal layer is preferably 1 nm or more and 2000 nm or less, preferably 100 nm or more and 1500 nm or less, more preferably 200 nm or more and 1000 nm or less, even more preferably 300 nm or more and 800 nm or less, and particularly preferably 350 nm or more and 500 nm or less. The thickness of the metal layer is a value measured by analyzing the layer section by an energy diffusive X-ray spectroscopic analyzer of a transmission electron microscope (TEM-EDX). Hereinafter, an example in which the metal layer is composed of two layers of a first metal layer and a second metal layer will be described.

The first metal layer preferably gives a desired function such as an etching stopper function and a reflection prevention function to the carrier-attached metal foil. Examples of the metal composing the first metal layer preferably include Ti, Al, Nb, Zr, Cr, W, Ta, Co, Ag, Ni, Mo, and combinations thereof, more preferably Ti, Zr, Al, Cr, W, Ni, Mo and combinations thereof, even more preferably Ti, Al, Cr, Ni, Mo, and combinations thereof, and particularly preferably Ti, Mo, and combinations thereof. These elements have properties that they do not dissolve into a flash etching solution (for example, copper flash etching solution), and as a result, can exhibit excellent chemical resistance to a flash etching solution. Accordingly, the first metal layer is a layer that is less likely to be etched by a flash etching solution than the second metal layer described later, and therefore, may function as an etching stopper layer. Further, since the aforementioned metal composing the first metal layer also has a function of preventing reflection of light, the first metal layer can also function as a reflection prevention layer for improving visibility in image inspection (for example, automatic image inspection (AOI)). The first metal layer may be a pure metal, or an alloy. The metal composing the first metal layer may contain unavoidable impurities due to raw material components, a film forming process and the like. Further, an upper limit of a content rate of the above-described metal is not particularly limited and may be 100at%. The first metal layer is preferably a layer formed by a physical vapor deposition (PVD) method, and more preferably a layer formed by sputtering. The thickness of the first metal layer is preferably 1 nm or more and 500 nm or less, more preferably 10 nm or more and 400 nm or less, even more preferably 30 nm or more and 300 nm or less, and particularly preferably 50 nm or more and 200 nm or less.

Examples of the metal composing the second metal layer preferably include transition elements of group 4, group 5, group 6, group 9, group 10, and group 11, Al, and combinations thereof (for example, alloys and intermetal compounds), more preferably transition elements of group 4 and group 11, Al, Nb, Co, Ni, Mo, and combinations thereof, even more preferably, transition elements of group 11, Ti, Al, Mo, and combinations thereof, and particularly preferably Cu, Ti, Mo, and combinations thereof, and most preferably Cu. The second metal layer may be produced by any method, and may be a metal foil formed by, for example, a wet film formation method such as an electroless metal plating method, and an electrolytic metal plating method, a physical vapor deposition (PVD) method such as sputtering and vacuum evaporation, chemical vapor deposition, or a combination thereof. The second metal layer is particularly preferably a metal layer formed by a physical vapor deposition (PVD) method such as a sputtering method and a vacuum evaporation, and is most preferably a metal layer produced by a sputtering method, from a viewpoint of easily responding to fine pitch due to super-thinning. Further, the second metal layer is preferably a metal layer that is not subjected to roughening treatment, but may be a metal layer that is subjected to secondary roughening treatment by preliminary roughening treatment, soft etching treatment, cleaning treatment, and oxidation-reduction treatment as long as it does not hinder wiring pattern formation. From the viewpoint of responding to fine pitch, the thickness of the second metal layer is preferably 10 nm or more and 1000 nm or less, more preferably 20 nm or more and 900 nm or less, even more preferably 30 nm or more and 700 nm or less, still more preferably 50 nm or more and 600 nm or less, particularly preferably 70 nm or more and 500 nm or less, and most preferably 100 nm or more and 400 nm or less. The metal layer having the thickness within such a range is preferably produced by a sputtering method from the viewpoint of in-plane uniformity of formed film thickness and productivity in sheet and roll forms.

When the metal layer has a single-layer configuration, the aforementioned second metal layer is preferably adopted as the metal layer as it is. On the other hand, when the metal layer has an n-layer (n is integer equal to or larger than 3) configuration, a first metal layer to an (n-1)^{th} metal layer of the metal layer are preferably have the configuration of the aforementioned first metal layer, and an outermost layer of the metal layer, that is, an n^{th} metal layer preferably has the configuration of the aforementioned second metal layer.

## Claims

1. A sheet fixing apparatus for fixing a multilayer sheet, comprising:
a support stage for supporting the multilayer sheet, the support stage having a plate-shaped member having a flat surface on which the multilayer sheet is placeable, a suction hole provided at a position corresponding to an outer peripheral portion of the multilayer sheet in the plate-shaped member, and a step portion provided along an outside of the suction hole in the plate-shaped member; and
suction means capable of sucking the multilayer sheet toward the support stage via the suction hole,
wherein the flat surface has a flatness of 0.30 mm or less as defined by JIS B0621-1984.

2. The sheet fixing apparatus according to claim 1, wherein a distance between the suction hole and the step portion is 30 mm or less.

3. The sheet fixing apparatus according to claim 1 or 2, wherein the suction hole has a recessed portion, and the recessed portion is provided with at least one through-hole penetrating through the plate-shaped member.

4. The sheet fixing apparatus according to claim 1 or 2, wherein when the support stage is seen in plan view, the suction hole has a shape along a contour of the multilayer sheet, and in the suction hole, a partition wall provided parallel to the contour of the multilayer sheet is present to divide the suction hole into a plurality of suction regions.

5. The sheet fixing apparatus according to claim 1 or 2, wherein when the support stage is seen in plan view, a shape of the suction hole is at least one selected from a group consisting of a circular shape, an arc shape, a straight-line shape, and a polygonal shape.

6. The sheet fixing apparatus according to claim 1 or 2, wherein the support stage has a plurality of the suction holes, and the plurality of suction holes are configured as an aggregate that brings about a circle, an arc, a straight line or a polygon as a whole.

7. The sheet fixing apparatus according to claim 1 or 2, wherein the support stage has a positioning pin for positioning the outer peripheral portion of the multilayer sheet onto the suction hole, on a top surface side of the flat surface.

8. The sheet fixing apparatus according to claim 1 or 2, wherein the flat surface has an arithmetic average roughness Ra of 0.01 µm or more and 0.50 µm or less.

9. The sheet fixing apparatus according to claim 1 or 2, wherein the plate-shaped member has a Vickers hardness of 10 HV or more and 3000 HV or less.

10. The sheet fixing apparatus according to claim 1 or 2, wherein the plate-shaped member is composed of at least one selected from a group consisting of stainless steel, Al alloy, carbon tool steel, alloy tool steel, high-speed tool steel, and Ti alloy.

11. The sheet fixing apparatus according to claim 1 or 2, wherein at least an end portion on the suction hole side of the step portion is rounded.

12. The sheet fixing apparatus according to claim 1 or 2, wherein the support stage further comprises a plurality of auxiliary suction holes, separately from the suction hole.

13. The sheet fixing apparatus according to claim 1 or 2, wherein the suction means comprises a lower stage disposed on a side opposite to the flat surface of the plate-shaped member, and the lower stage comprises a gas flow path communicating with the suction hole.

14. The sheet fixing apparatus according to claim 12, wherein the suction means comprises a lower stage disposed on a side opposite to the flat surface of the plate-shaped member, and the lower stage comprises a gas flow path communicating with the suction hole and the auxiliary suction holes, or comprises a gas flow path communicating with the suction hole and a gas flow path communicating with the auxiliary suction holes separately.

15. The sheet fixing apparatus according to claim 13, wherein the suction means further comprises a suction pump connected to the gas flow path.

16. A sheet releasing apparatus for releasing a multilayer sheet, comprising:
the sheet fixing apparatus according to claim 1 or 2; and
stress load means for applying stress in contact with the multilayer sheet, the stress load means being provided adjacently to the support stage or provided in the step portion of the support stage, and having a movable contact portion movable to above the flat surface while being in contact with the multilayer sheet.

17. The sheet releasing apparatus according to claim 16, wherein the movable contact portion has a pin shape or a hook shape.

18. A method for releasing a sheet, using the sheet releasing apparatus according to claim 16, comprising the steps of:
placing a multilayer sheet comprising at least a first layer and a second layer so that a surface of the first layer is in contact with a flat surface of the support stage;
sucking the multilayer sheet toward the support stage via the suction hole by the suction means, thereby fixing the multilayer sheet to the support stage; and
by the stress load means, bringing the movable contact portion into contact with the second layer of the multilayer sheet from the step portion, applying stress in a direction in which the first layer and the second layer are separated from each other, thereby releasing the second layer from the first layer,
wherein a contact region of the movable contact portion and the multilayer sheet has a maximum length of 2 mm or more and 500 mm or less.

19. The method for releasing a sheet according to claim 18, wherein the contact region of the movable contact portion and the multilayer sheet has an area of 5 mm² or more and 120 mm² or less.

20. The method for releasing a sheet according to claim 18, further comprising a step of applying grease to the surface of the first layer of the multilayer sheet and/or the flat surface of the support stage, before placing the multilayer sheet on the support stage.

21. The method for releasing a sheet, comprising a step of fixing one surface of a multilayer sheet by using the sheet fixing apparatus according to claim 1 or 2, and releasing a layer on an opposite side to the one surface.
